# EUROPÄISCHE PATENTANMELDUNG

(11) **EP 4 704 504 A1**
(43) Veröffentlichungstag der Anmeldung: **04.03.2026**
(21) Anmeldenummer: 24197083.9
(22) Anmeldetag: 28.08.2024
(51) Int. Cl.: H05K 7/20

(54) **KONSTRUKTIVER AUFBAU ZUR VERTEILUNG DER VERLUSTLEISTUNG AUF BEIDE SEITENWÄNDE**

(71) Anmelder: Siemens Aktiengesellschaft, 80333 München (DE)
(72) Erfinder: Portisch, Daniel, 2170 Poysdorf (AT); Petricek, Martin, 2020 Hollabrunn (AT)
(74) Vertreter: Siemens Patent Attorneys

(57) **Zusammenfassung**

Die Erfindung betrifft ein elektronisches Gerät (1), insbesondere ein Stromversorgungssystem, umfassend
- ein Gehäuse (2);
- eine erste elektronische Baugruppe (3), insbesondere eine erste Stromversorgungseinheit, umfassend einen ersten Kühlkörper (4); und
- eine zweite elektronische Baugruppe (5), insbesondere eine zweite Stromversorgungseinheit, umfassend einen zweiten Kühlkörper (6);
- wobei die erste und die zweite elektronische Baugruppe (3, 5) im Gehäuse (2) angeordnet sind; und
- der erste Kühlkörper (4) und der zweite Kühlkörper (6) über Anpresselemente (7) innen an das Gehäuse (2) angepresst sind.

## Beschreibung

Die gegenständliche Erfindung betrifft allgemein das Gebiet der Elektrotechnik, insbesondere den Bereich der Leistungselektronik. Im Speziellen bezieht sich die vorliegende Erfindung auf ein elektronisches Gerät, insbesondere ein Stromversorgungssystem.

### Stand der Technik

Bisher werden in elektronischen Geräten mit mehr als einer seitlich angeordneten Leiterplatte die bestückten Leiterplatten auf jeweils außenliegende Kühlkörper bzw. Kühlplatten geschraubt und anschließend die Leiterplatten miteinander verschraubt. Dieser Verbund aus Kühlkörper-Leiterplatte-Leiterplatte-Kühlkörper wurde dann in ein Gehäuse aus Metall eingesetzt. Mechanische Toleranzen führen jedoch dazu, dass die Kühlkörper nicht vollflächig innen an den Seitenwänden des Gehäuses anliegen. Eine schlechte Kühlleistung ist die Folge. Diese muss toleriert werden oder durch zusätzliche aufwendige und kostenintensive Kühlmaßnahmen wie bspw. Heatpipes verbessert werden.

Die Aufgabe der vorliegenden Erfindung ist es, eine verbesserte Kühlung des elektronischen Geräts ohne aufwendige oder kostenintensive Maßnahmen zu erreichen.

### Lösung der Aufgabe

Die Aufgabe wird gelöst durch ein Elektronisches Gerät, insbesondere ein Stromversorgungssystem, umfassend
- ein Gehäuse;
- eine erste elektronische Baugruppe, insbesondere eine erste Stromversorgungseinheit, umfassend einen ersten Kühlkörper; und
- eine zweite elektronische Baugruppe, insbesondere eine zweite Stromversorgungseinheit, umfassend einen zweiten Kühlkörper;
- wobei die erste und die zweite elektronische Baugruppe im Gehäuse angeordnet sind; und
- der erste Kühlkörper und der zweite Kühlkörper über Anpresselemente innen an das Gehäuse angepresst sind.

Durch die Aufteilung des Stromversorgungssystems in eine erste und eine zweite elektronische Baugruppe findet eine optimale Verteilung der Verlustleistung im elektronischen Gerät statt. Die Anpresselemente ermöglichen eine passgenaue Anpressung der Kühlkörper innen an das Gehäuse, womit Bauteiltoleranzen, insbesondere des Gehäuses, ausgeglichen werden.

Vorteilhaft ist es, wenn zumindest ein Anpresselement als Zapfen ausgebildet ist, der von der ersten und/oder zweiten elektronischen Baugruppe umfasst ist, wobei der Zapfen mit Ausnehmungen im Gehäuse zusammenwirkt.

Durch die Ausgestaltung zumindest eines Anpresselements als Zapfen wird eine optimale Anpressung der elektronischen Baugruppen innen an das Gehäuse erreicht, nachdem die elektronischen Baugruppen in das Gehäuse eingeschoben wurden. Der Zapfen wird dabei bevorzugt durch eine Isolierung gebildet, kann aber auch durch eine Leiterplatte oder einen Kühlkörper gebildet werden. Der Zapfen ist elastisch ausgebildet. Der Zapfen kann eine Abschrägung bzw. Auflaufschrägung aufweisen. Die Abschrägung erleichtert das Einführen des Zapfens in eine Ausnehmung im Gehäuse. Das Zusammenwirken des Zapfens mit einer Ausnehmung funktioniert derart, dass der Zapfen an eine Innenkante der Ausnehmung drückt und damit die elektronische Baugruppe bzw. den Kühlkörper nach außen drückt und den Kühlkörper innen an das Gehäuse presst.

Vorteilhaft ist es, wenn das elektronische Gerät weiters eine Verbindungsplatine umfasst, über die die erste und die zweite elektronische Baugruppe elektrisch und mechanisch miteinander verbunden sind, und zumindest ein Anpresselement als Federelement ausgebildet ist, welches von der Verbindungsplatine umfasst ist.

Die Ausführung des Anpresselements als Federelement stellt eine weitere vorteilhafte Möglichkeit dar, die Kühlkörper innen an das Gehäuse anzupressen und damit Bauteiltoleranzen des Gehäuses auszugleichen und einen optimalen Wärmeübergang vom Kühlkörper auf das Gehäuse sicherzustellen.

Vorteilhaft ist es, wenn die Verbindungsplatine in eine erste Teil-Verbindungsplatine und eine zweite Teil-Verbindungsplatine zweigeteilt ist und das Federelement eine Federung zwischen der ersten und der zweiten Teil-Verbindungsplatine bewirkt.

Durch diese Maßnahme wird die Anpressung der Kühlkörper innen an das Gehäuse weiter verbessert.

Vorteilhaft ist es, wenn das Federelement durch einen elastischen Fortsatz der ersten Teil-Verbindungsplatine gebildet ist, der mit der zweiten Teil-Verbindungsplatine zusammenwirkt.

Durch diese Maßnahme ist eine besonders einfache Herstellung des Federelements ohne zusätzliche Bauteile möglich.

Vorteilhaft ist es, wenn der erste und der zweite Kühlkörper an gegenüberliegende Seitenwände des Gehäuses angepresst sind.

Durch diese Maßnahme wird die Verteilung der Verlustleistung im Gehäuse weiter optimiert. Die Seitenwände des Gehäuses können damit bestmöglich zur Kühlung genutzt werden. Außerdem sind die Kühlkörper damit weitestmöglich voneinander entfernt, was eine gegenseitige Erwärmung verhindert.

Vorteilhaft ist es, wenn die erste und die zweite elektronische Baugruppe eine gleiche elektrische Funktionalität aufweisen und parallelgeschaltet sind.

Unter einer gleichen elektrischen Funktionalität ist zu verstehen, dass die erste und die zweite elektronische Baugruppe einen gleichen Einsatzzweck erfüllen. Beispielsweise ist jede der beiden elektronischen Baugruppen eine Stromversorgungseinheit. Durch diese Maßnahme ist es möglich, ein elektronisches Gerät bzw. ein Stromversorgungssystem in zwei elektronische Baugruppen bzw. zwei Stromversorgungseinheiten aufzuteilen, welche jeweils eine Hälfte eines geforderten Nennstroms oder einer geforderten Nennleistung des elektronischen Geräts bzw. des Stromversorgungssystems bereitstellen. Die Aufteilung in zwei elektronische Baugruppen bzw. zwei Stromversorgungseinheiten ermöglicht dann die räumlich getrennte Anordnung der elektronischen Baugruppen zur optimalen Verteilung der Verlustleistung im elektronischen Gerät.

Vorteilhaft ist es, wenn das elektronische Gerät weiters ein erstes Befestigungselement umfasst, welches formschlüssig in einer ersten Leiterplatte der ersten elektronischen Baugruppe oder in einer zweiten Leiterplatte der zweiten elektronischen Baugruppe angeordnet ist; ein Gewinde und zumindest einen Federarm aufweist; und mit der ersten oder zweiten elektronischen Baugruppe derart verschraubt ist, dass durch das erste Befestigungselement, insbesondere durch den zumindest einen Federarm, eine Kraft ausgeübt ist, welche die erste Leiterplatte an den ersten Kühlkörper oder die zweite Leiterplatte an den zweiten Kühlkörper drückt.

Durch diese Maßnahme wird ein optimaler Wärmeübergang von der Leiterplatte auf den Kühlkörper gewährleistet.

Vorteilhaft ist es, wenn das elektronische Gerät weiters ein zweites Befestigungselement umfasst, welches seitlich an einer Leiterplatte befestigt ist und durch welches ein elektronisches Bauteil zwischen dem Kühlkörper und dem zweiten Befestigungselement an den Kühlkörper anpressbar ist.

Durch diese Maßnahme wird eine verbesserte Kontaktierung von elektronischen Bauelementen am Kühlkörper erreicht.

Vorteilhaft ist es, wenn das elektronische Gerät ein Stromversorgungssystem, die erste elektronische Baugruppe eine erste Stromversorgungseinheit und die zweite elektronische Baugruppe eine zweite Stromversorgungseinheit ist.

Durch diese Maßnahme wird in besonders vorteilhafter Weise ein Stromversorgungssystem gebildet, dessen beide Stromversorgungseinheiten verteilt im Gehäuse angeordnet sind und somit die die Verlustleistungen der beiden Stromversorgungseinheiten verteilt im elektronischen Gerät auftreten.

Die Aufgabe wird außerdem gelöst durch ein Verfahren zur Montage eines elektronischen Geräts wobei die erste und die zweite elektronische Baugruppe in das Gehäuse eingeschoben werden und der erste Kühlkörper und der zweite Kühlkörper über Anpresselemente innen an das Gehäuse angepresst werden.

Dieses Verfahren bewirkt in vorteilhafter Weise, dass Bauteiltoleranzen des Gehäuses ausgeglichen werden und die Kühlkörper innen an das Gehäuse angepresst werden und vollständig bzw. vollflächig am Gehäuse anliegen. Das Verfahren ist einfach und automatisiert ausführbar.

Vorteilhaft ist es, wenn die erste und die zweite Teil-Verbindungsplatine elektrisch miteinander verbunden werden.

Das Verbinden der Teil-Verbindungsplatinen nach dem Einschub der elektronischen Baugruppen in das Gehäuse bewirkt, dass das als Federelement ausgebildete Anpresselement zuerst die Kühlkörper an das Gehäuse anpressen kann, bevor diese Position durch die Verbindung der Teil-Verbindungsplatinen festgestellt wird.

### Figurenbeschreibung

Die Erfindung sowie weitere vorteilhafte Ausgestaltungen der Erfindung gemäß Merkmalen der Unteransprüche werden im Folgenden anhand von Ausführungsbeispielen in den Figuren näher erläutert. Es zeigen:
FIG 1 einen beispielhaften konstruktiven Aufbau eines erfindungsgemäßen elektronischen Geräts in einer ersten Darstellung ohne Kühlkörper und Gehäuse,
FIG 2 einen beispielhaften konstruktiven Aufbau eines erfindungsgemäßen elektronischen Geräts in einer zweiten Darstellung mit Kühlkörpern und ohne Gehäuse,
FIG 3 einen beispielhaften konstruktiven Aufbau eines erfindungsgemäßen elektronischen Geräts in einer dritten Darstellung mit Kühlkörpern und ohne Gehäuse,
FIG 4 einen beispielhaften konstruktiven Aufbau eines erfindungsgemäßen elektronischen Geräts in einer vierten Darstellung mit Kühlkörpern in einem Gehäuse,
FIG 5 eine beispielhafte erste Detailansicht eines als Zapfen ausgebildeten Anpresselements,
FIG 6 eine beispielhafte zweite Detailansicht eines als Zapfen ausgebildeten Anpresselements,
FIG 7 eine beispielhafte Darstellung einer Verbindungsplatine mit einem als Federelement ausgebildeten Anpresselement,
FIG 8 eine beispielhafte Darstellung eines Schritts des Verfahrens zur Montage des elektronischen Geräts,
FIG 9 eine Detailansicht eines als Federelement ausgebildeten Anpresselements,
FIG 10 eine beispielhafte Darstellung der Verbindungsplatine des elektronischen Geräts mit nicht-dargestellter Frontkappe,
FIG 11 eine beispielhafte erste Darstellung eines ersten Befestigungselements,
FIG 12 eine beispielhafte zweite Darstellung eines ersten Befestigungselements,
FIG 13 eine beispielhafte dritte Darstellung eines ersten Befestigungselements,
FIG 14 eine beispielhafte vierte Darstellung eines ersten Befestigungselements,
FIG 15 eine beispielhafte erste Darstellung eines zweiten Befestigungselements,
FIG 16 eine beispielhafte zweite Darstellung eines zweiten Befestigungselements, und
FIG 17 eine beispielhafte dritte Darstellung eines zweiten Befestigungselements.

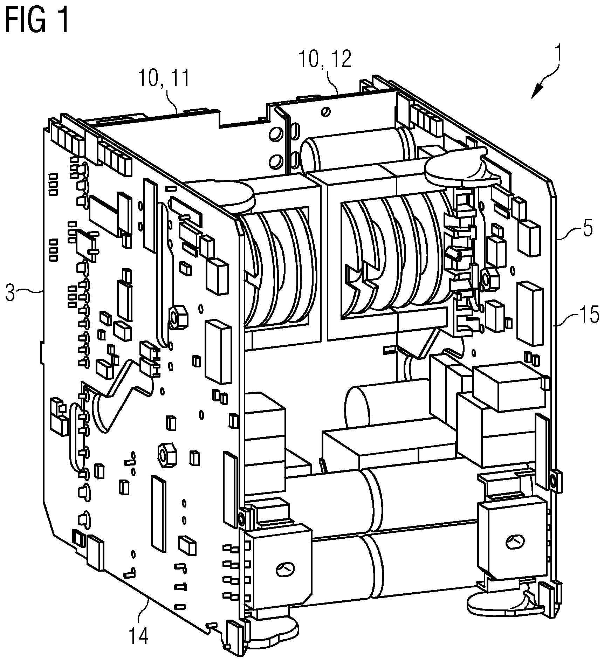

FIG 1 zeigt einen beispielhaften konstruktiven Aufbau eines erfindungsgemäßen elektronischen Geräts 1 in einer ersten Darstellung ohne Kühlkörper und Gehäuse. Dargestellt sind das elektronische Gerät 1, welches in diesem Ausführungsbeispiel ein Stromversorgungssystem ist. Die Fig. 1 zeigt weiters eine erste elektronische Baugruppe 3 und eine zweite elektronische Baugruppe 5, welche in diesem Ausführungsbeispiel eine erste Stromversorgungseinheit 3 und eine zweite Stromversorgungseinheit 5 sind. Die erste elektronische Baugruppe 3 umfasst eine erste Leiterplatte 14 und die zweite elektronische Baugruppe 5 umfasst eine zweite Leiterplatte 15. Die erste Leiterplatte 14 und die zweite Leiterplatte 15 sind mit verschiedenen elektronischen Bauelementen bestückt ist. Weiters ist eine Verbindungsplatine 10 dargestellt. Die beiden Stromversorgungseinheiten 3, 5 sind über die Verbindungsplatine 10 elektrisch und mechanisch miteinander verbunden. Die elektronischen Baugruppen 3, 5, insbesondere deren Leiterplatten 14, 15, sind in diesem Beispiel parallel zueinander und entlang der Seitenwände des Gehäuses 2 angeordnet, während die Verbindungsplatine 10 jeweils normal auf die elektronischen Baugruppen 3, 5, insbesondere deren Leiterplatten 14, 15, steht.

In diesem Beispiel sind die erste Stromversorgungseinheit 3 und eine zweite Stromversorgungseinheit 5 parallelgeschaltet und bilden zusammen ein Stromversorgungssystem. Ein 40A-Stromversorgungssystem ist dabei zweigeteilt in zwei 20A-Stromversorgungseinheiten 3, 5. Dies bewirkt die Verteilung der Verlustleistung durch Realisierung des 40A-Stromversorgungssystems durch zwei 20A-Stromversorgungseinheiten 3, 5, wobei jeweils eine Seitenwand des Gehäuses 2 die vollständige Kühlung einer 20A-Stromversorgungseinheit 3, 5 übernimmt, was wiederum zur Leistungsverteilung über beide Seiten des Gehäuses 2 führt. Die beiden elektronischen Baugruppen 3, 5 sind dabei spiegelbildlich angeordnet, um jeweils nach links außen und nach rechts außen zu kühlen.

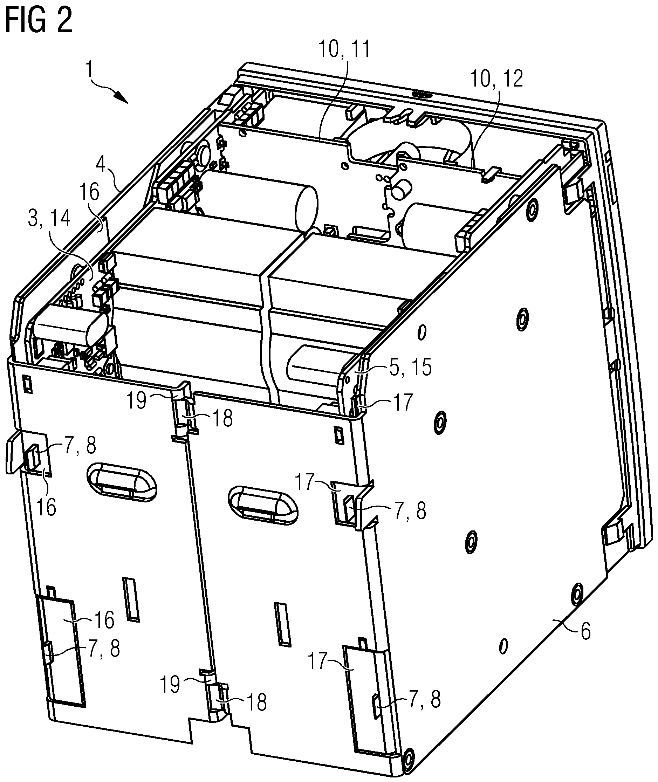

Fig. 2 zeigt einen beispielhaften konstruktiven Aufbau eines erfindungsgemäßen elektronischen Geräts 1 in einer zweiten Darstellung mit Kühlkörpern 4, 6 und ohne Gehäuse 2. Dargestellt sind die erste elektronische Baugruppe 3 mit der ersten Leiterplatte 14 und die zweite elektronische Baugruppe 5 mit der zweiten Leiterplatte 15. Weiters dargestellt sind der erste Kühlkörper 4 und der zweite Kühlkörper 6. Die Kühlkörper 4, 6 sind dabei als L-förmige Kühlkörper ausgeführt, die entlang jeweils gegenüberliegender Seitenwände des nicht dargestellten Gehäuses 2 und jeweils entlang der ersten Leiterplatte 14 und der zweiten Leiterplatte 15 verlaufen. Weiters dargestellt sind eine erste Isolierung 16 und eine zweite Isolierung 17. Die Isolierungen 16, 17 sind als Isolierplatten ausgeführt, die jeweils zumindest teilweise zwischen der ersten Leiterplatte 14 und dem ersten Kühlkörper 4 sowie zwischen der zweiten Leiterplatte 15 und dem zweiten Kühlkörper 6 verlaufen. Die Isolierungen 16, 17 weisen nicht dargestellte Öffnungen auf, in denen Keramik-Isolierkörper eingesetzt sind, welche für einen Wärmeübergang ausgelegt sind. Die Keramikisolierkörper kontaktieren jeweils sowohl eine Leiterplatte 14, 15 und einen Kühlkörper 4, 6 und sorgen für einen Wärmeübergang zwischen der jeweiligen Leiterplatte 14, 15, insbesondere von thermisch beanspruchten elektronischen Bauelementen auf der jeweiligen Leiterplatte 14, 15, auf den jeweiligen Kühlkörper 4, 6. Die erste Leiterplatte 14, die erste Isolierung 16 und der erste Kühlkörper 4 sind miteinander verbunden, in diesem Beispiel verschraubt. Ebenso sind die zweite Leiterplatte 15, die zweite Isolierung 17 und der zweite Kühlkörper 6 miteinander verbunden, in diesem Beispiel verschraubt. Diese Verbindungen bzw. Verschraubungen werden bereits vor einem Einbau der elektronische Baugruppen 3, 5 in das Gehäuse 2 ausgeführt.

Die beiden elektronischen Baugruppen 3, 5 sind im dargestellten, nicht-montierten Zustand zueinander beweglich. Die Kühlkörper 4, 6 weisen an einem ihrer Enden zusammen ein System aus Lasche 18 und Bügel 19 auf, wobei die Lasche 18 in den Bügel 19 eingeführt ist. Durch die Lasche 18 und den Bügel 19 wird eine Beweglichkeit der elektronischen Baugruppen zueinander und voneinander weg im nicht-montierten Zustand, d.h. vor und während einem Einbau in das Gehäuse 2, gewährleistet.

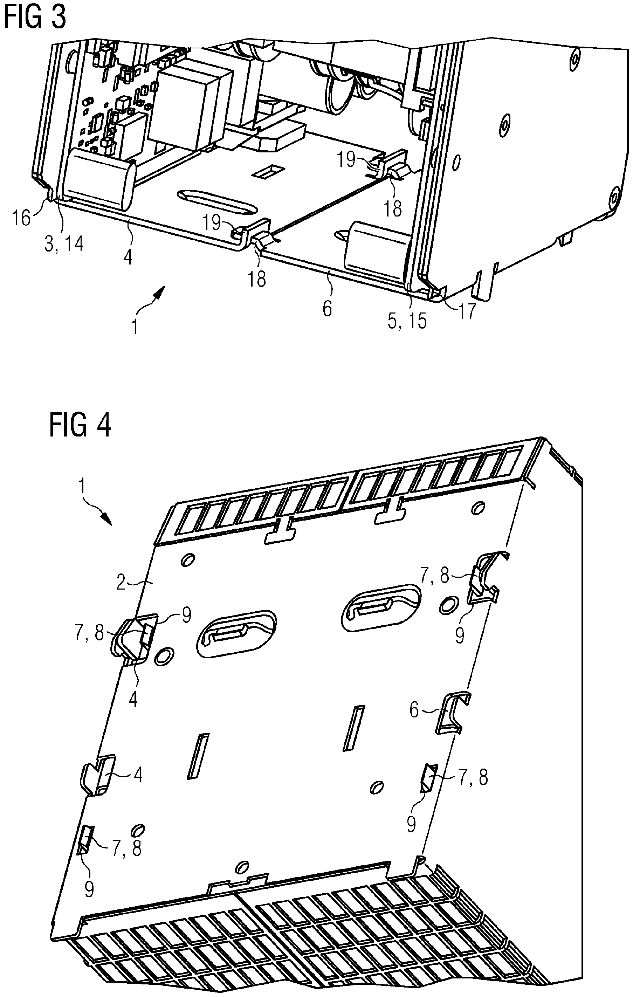

Dargestellt sind weiters mehrere Anpresselemente 7. In diesem Beispiel sind vier Anpresselemente 7 als Zapfen 8 ausgeführt. Die Zapfen 8 sind in diesem Beispiel Teil der Isolierungen 16, 17. Die Zapfen 8 weisen zu einer Rückseite des Geräts 1 bzw. des nicht dargestellten Gehäuses 2. Die Zapfen 8 weisen Abschrägungen auf, welche den Einschub in das Gehäuse 2 erleichtern. Dies wird in den Fig. 4-7 weiter ausgeführt.

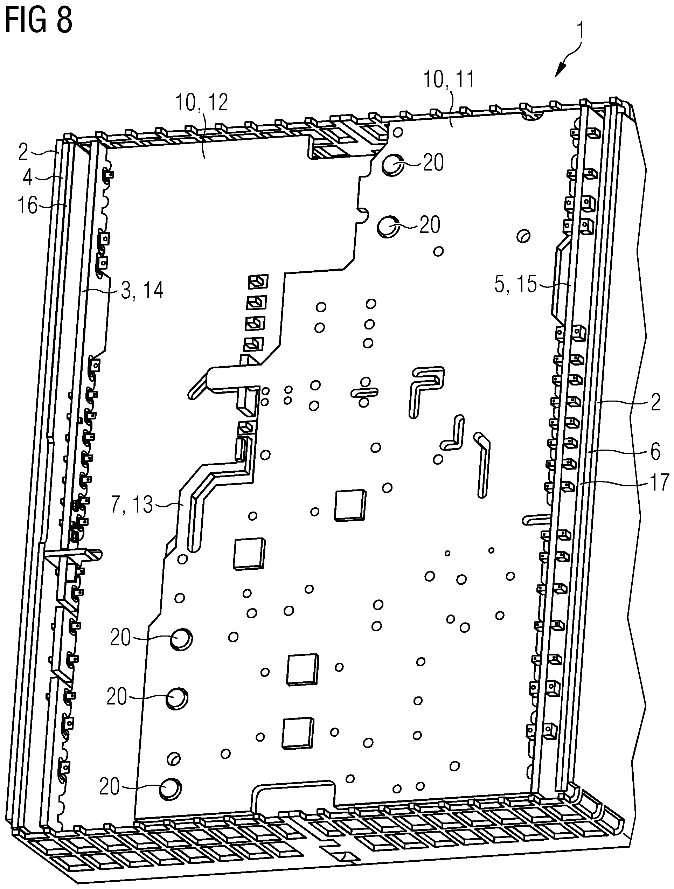

Dargestellt ist weiters eine Verbindungsplatine 10, über die die erste und die zweite elektronische Baugruppe 3, 5 elektrisch und mechanisch miteinander verbunden sind. Die Verbindungsplatine 10 ist in diesem Beispiel in eine erste Teil-Verbindungsplatine 11 und eine zweite Teil-Verbindungsplatine 12 zweigeteilt. Die beiden Teil-Verbindungsplatinen 11, 12 überlappen sich dabei teilweise. Dies wird in den Fig. 8-10 weiter ausgeführt.

Dargestellt ist außerdem eine Frontkappe, welche sich in dieser Darstellung im hinteren Teil des Elektronischen Geräts 1 befindet. Die Frontkappe umfasst Anzeige- und Bedienelemente sowie Datenschnittstellen und Leistungsanschlüsse.

Fig. 3 zeigt einen beispielhaften konstruktiven Aufbau eines erfindungsgemäßen elektronischen Geräts 1 in einer dritten Darstellung mit Kühlkörpern 4, 6 und ohne Gehäuse 2. Die Darstellung dient zur weiteren Veranschaulichung des Systems aus Lasche 18 und Bügel 19. Durch das System wird vor und während des Einbaus der elektronischen Baugruppen 3, 5 in das Gehäuse 2 eine mechanische Stabilität erhöht und der Einbau vereinfacht, da die elektronischen Baugruppen 3, 5 nur in einer Achse beweglich sind.

Fig. 4 zeigt einen beispielhaften konstruktiven Aufbau eines erfindungsgemäßen elektronischen Geräts 1 in einer vierten Darstellung mit Kühlkörpern 4, 6 in einem Gehäuse 2. Dargestellt ist eine Ansicht auf eine Rückwand des Gehäuses 2 bzw. des elektronischen Geräts 1. Das Gehäuse 2 bzw. die Rückwand des Gehäuses 2 weist dabei Ausnehmungen 9 auf, in diesem Beispiel vier Ausnehmungen 9. Die Ausnehmungen 9 sind so angeordnet, dass die Anpresselemente 7 bzw. die Zapfen 8 bei einem Einschub der elektronischen Baugruppen 3, 5 in die Ausnehmungen 9 eingeführt werden. Die Abschrägungen der Anpresselemente 7 bzw. der Zapfen 8 unterstützen das Einführen. Gleichzeitig werden die Anpresselemente 7 bzw. die Zapfen 8 durch die Ausnehmungen 9 nach außen hin zu den jeweiligen Seitenwänden des Gehäuses 2 gedrückt. Damit werden die jeweiligen elektronischen Baugruppen 3, 5 und insbesondere die jeweiligen Kühlkörper 4, 6 innen an die Seitenwände des Gehäuses 2 gepresst. Durch diese Maßnahme wird ein optimaler Wärmeübergang der Kühlkörper 4, 6 an das Gehäuse 2 gewährleistet. Insbesondere werden damit mechanische Toleranzen des Gehäuses 2 ausgeglichen, die sonst ein vollständiges Anliegen der Kühlkörper 4, 6 am Gehäuse 2 verhindern würden. Die Isolierungen 16, 17 sind dabei aus einem Isoliermaterial ausgeführt, das elastisch ist und eine Anpressung begünstigt.

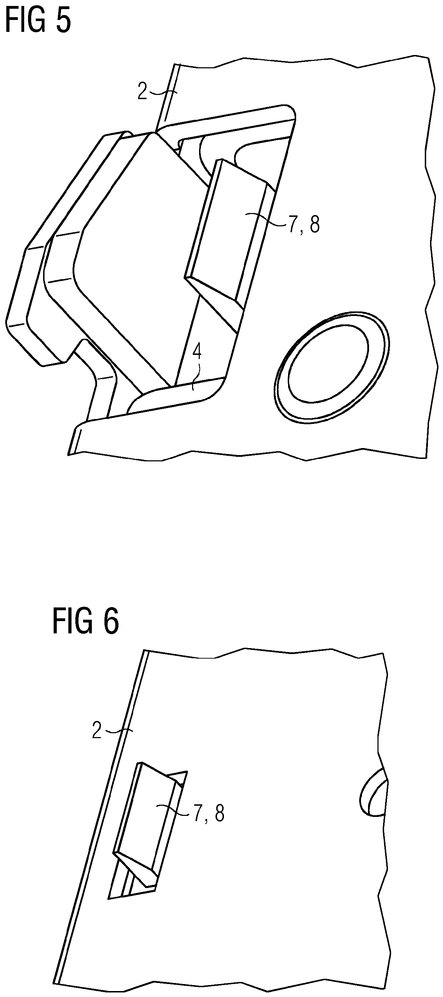

Die Fig. 5 und 6 zeigen jeweils eine beispielhafte erste und zweite Detailansicht eines als Zapfen 8 ausgebildeten Anpresselements 7.

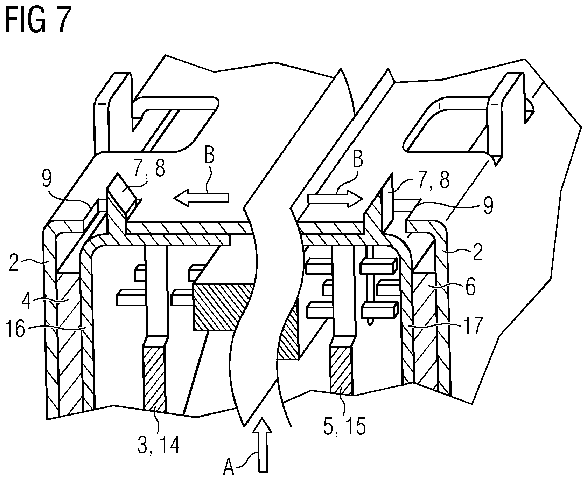

Fig. 7 zeigt eine beispielhafte Darstellung eines Schritts des Verfahrens zur Montage des elektronischen Geräts 1. Gezeigt ist, wie ein im Wesentlichen aus den in Fig. 2 dargestellten Komponenten bestehender Block, bestehend aus den elektronischen Baugruppen 3, 5, umfassend die Kühlkörper 4, 6, in das Gehäuse 2 in einer Montagerichtung A eingeschoben wird. Die Anpresselemente 7, 8, in diesem Beispiel die durch die Isolierungen 16, 17 gebildeten Zapfen 8, wirken mit Ausnehmungen 9 im Gehäuse 2 zusammen. Die Anpresselemente 7, 8 pressen die Kühlkörper 4, 6 nach dem vollständigen Einschub jeweils in einer Anpressrichtung B an die Innenseiten des Gehäuses 2 an.

Fig. 8 zeigt eine beispielhafte Darstellung einer Verbindungsplatine 10 mit einem als Federelement 13 ausgebildeten Anpresselement 7. Die Verbindungsplatine 10 ist dabei in eine erste Teil-Verbindungsplatine 11 und eine zweite Teil-Verbindungsplatine 12 zweigeteilt. In einem nicht-montierten Zustand sind die beiden Teil-Verbindungsplatinen 11, 12 zueinander und voneinander weg beweglich gelagert. Dies wird in diesem Beispiel durch Fortsätze bewirkt, die auf den Teil-Verbindungsplatinen 11, 12 ausgebildet sind. Weiters ist von der ersten Teil-Verbindungsplatine 11 ein Anpresselement 7 umfasst, dass in diesem Beispiel als Federelement 13 ausgebildet ist. In diesem Beispiel ist das Federelement 13 durch die erste Teil-Verbindungsplatine 11 selbst als elastischer Fortsatz der Teil-Verbindungsplatine 11 ausgebildet. Das Federelement 13 wirkt einer Bewegung der Teil-Verbindungsplatinen 11, 12 entgegen und bewirkt eine Kraft der Teil-Verbindungsplatinen 11, 12 nach außen hin zu den Seitenwänden des Gehäuses 2, wenn die Teil-Verbindungsplatinen 11, 12 zueinander gedrückt werden. Dieser Druck zueinander entsteht beim Einschub der elektronischen Baugruppen 3, 5 beim Einschub in das Gehäuse 2. Die dabei entstehende Kraft wirkt über die elektronischen Baugruppen 3, 5 auf die Kühlkörper 4, 6, womit die Kühlkörper 4, 6 an die Innenseiten des Gehäuses angepresst werden. Nach dem Einschub der elektronischen Baugruppen 3, 5 in das Gehäuse 2 werden die Teil-Verbindungsplatinen 11, 12 miteinander verbunden, sodass diese nicht mehr beweglich sind. Die Verbindung wird in diesem Beispiel über Verschraubungen 20 ausgeführt. Die Verschraubungen stellen auch eine elektrische Verbindung zwischen den Teil-Verbindungsplatinen 11, 12 her.

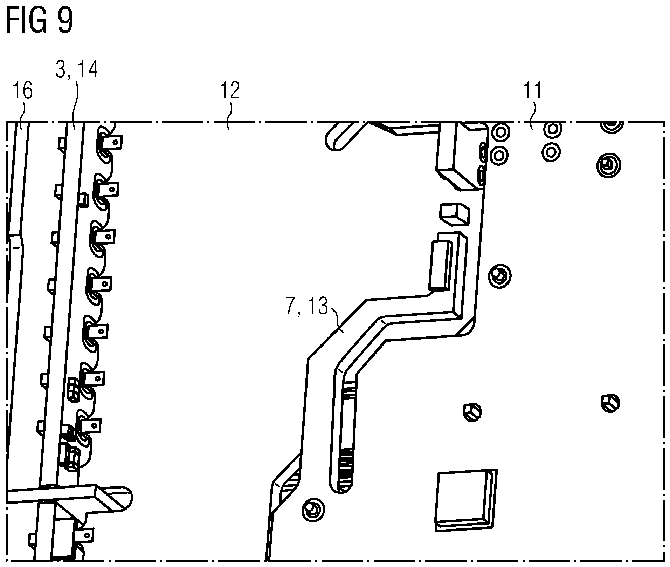

Fig. 9 zeigt eine Detailansicht eines als Federelement 13 ausgebildeten Anpresselements 7. Das Federelement 13 bewirkt eine Federung zwischen der ersten Teil-Verbindungsplatine 11 und der zweiten Teil-Verbindungsplatine 12. Das Federelement 13 ist in diesem Beispiel einstückig als Fortsatz der ersten Teil-Verbindungsplatine 11 ausgebildet.

Durch die als Zapfen 8 ausgebildeten Anpresselemente 7 ist eine Anpressung der Kühlkörper 4, 6 in einem rückwärtigen Bereich des Gehäuses 2 gewährleistet während durch das als Federelement 13 ausgebildete Anpresselement 7 eine Anpressung der Kühlkörper 4, 6 in einem vorderen Bereich des Gehäuses 2 gewährleistet ist.

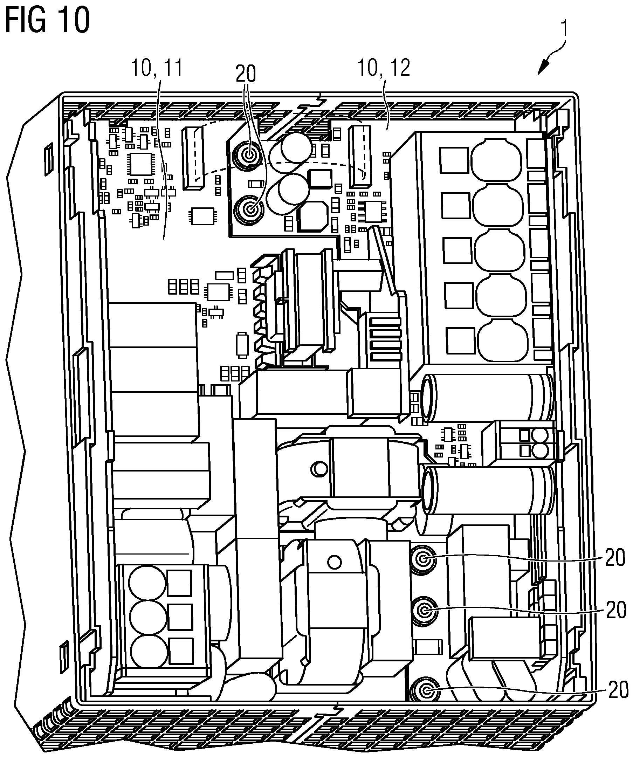

Fig. 10 zeigt eine beispielhafte Darstellung der Verbindungsplatine 10 des elektronischen Geräts 1 mit nicht-dargestellter Frontkappe. Dargestellt sind die erste Teil-Verbindungsplatine 11 und die zweite Teil-Verbindungsplatine 12. Die beiden Teil-Verbindungsplatinen 11, 12 sind über Verbindungen 20, in diesem Beispiel Verschraubungen, miteinander verbunden. Fig. 10 stellt das elektronische Gerät 1 somit in einem montierten Zustand dar. Die Verbindungen verbinden die beiden Teil-Verbindungsplatinen mechanisch und elektrisch. Eine Bewegung der beiden Teil-Verbindungsplatinen relativ zueinander ist nach der Verbindung nicht mehr möglich. Auf einer der beiden Teil-Verbindungsplatinen, in diesem Beispiel auf der ersten Teil-Verbindungsplatine 11, sind im Bereich der Verbindungen 20 Langlöcher auf der Platine angeordnet. Auf der anderen der beiden Teil-Verbindungsplatinen, in diesem Beispiel auf der zweiten Teil-Verbindungsplatine 12, sind im Bereich der Verbindungen 20 Löcher auf der Platine angeordnet. Die Löcher und die Langlöcher oder der Bereich um die Löcher und die Langlöcher können metallisiert sein. Durch die Löcher und die Langlöcher wird eine Verbindung der Teil-Verbindungsplatinen 11, 12 nach dem Einschub der elektronischen Baugruppen 3, 5 in das Gehäuse 2 ermöglicht, da die Kombination aus Loch und Langloch jeweils eine relative Bewegung der Teil-Verbindungsplatinen 11, 12 zueinander ausgleicht. Durch die Verbindungen 20 werden die Teil-Verbindungsplatinen 11, 12 relativ zueinander festgestellt bzw. fixiert und eine elektrische Verbindung zwischen den Teil-Verbindungsplatinen 11,12 zueinander hergestellt. Die Verbindungen 20 werden nach einem Einschub der elektronischen Baugruppen 3, 5 in das Gehäuse 2 eingebracht. Zusätzlich ist im oberen Bereich der Verbindungsplatine 10 ein Flachbandkabel dargestellt, über welches die Teil-Verbindungsplatinen zusätzlich elektrisch verbunden sind.

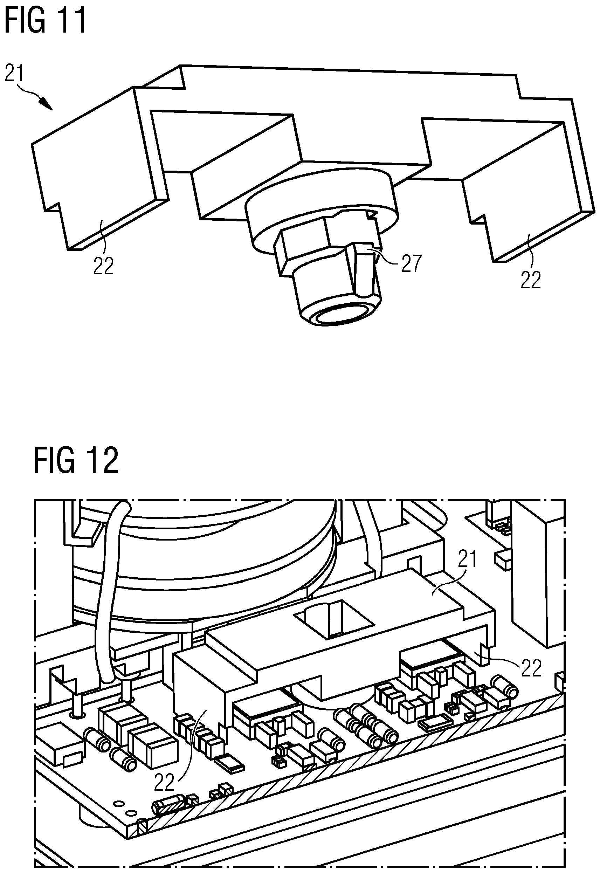

Fig. 11 zeigt eine beispielhafte erste Darstellung eines ersten Befestigungselements 21. Das erste Befestigungselement 21 umfasst einen Körper mit einem innenliegenden Gewinde 26 und zumindest einen Federarm 22, in diesem Beispiel zwei Federarme 22. Das erste Befestigungselement ist ein Spritzgussteil, wobei das Gewinde ebenfalls gespritzt oder ein eingespritztes Metallgewinde sein kann. Der Körper umfasst einen Teil, der in bzw. durch eine Leiterplatte 14, 15 gesteckt werden kann. Der Teil umfasst einen Verdrehschutz, in diesem Beispiel einen sechskantigen Abschnitt, und einen Rasthaken 27. Der sechskantige Abschnitt befindet sich, wenn das erste Befestigungselement 21 in die Leiterplatte 14, 15 gesteckt wurde, in einer Ausnehmung der Leiterplatte 14, 15 und dient als Verdrehschutz. Der Rasthaken befindet sich in diesem Fall auf einer dem restlichen ersten Befestigungselement 21 gegenüberliegenden Seite der Leiterplatte und verhindert ein Herauslösen des ersten Befestigungselements 21. Durch den Körper des ersten Befestigungselements 21 verläuft eine Ausnehmung, in der sich das Gewinde 26 befindet. Das erste Befestigungselement 21 kann durch eine von der Seite des Rasthakens 27 kommende Seite mit der Leiterplatte verschraubt werden. Bei einer Verschraubung drücken die Federarme 22 auf die Leiterplatte 14, 15. Außerdem befindet sich am Körper des ersten Befestigungselements 21 eine Stufe, die ebenso wie die Federarme 22 auf der Leiterplatte 14, 15 aufliegt und bei einer Verschraubung eine Kraft auf die Leiterplatte 14, 15 überträgt. Bei einer Verschraubung werden zuerst die Federarme 22 auf die Leiterplatte 14, 15 gedrückt, bevor die Stufe auf die Leiterplatte drückt. Dies hat eine vorteilhafte Wirkung für die Anpressung, da die Federarme 22 federnd ausgebildet sind.

Fig. 12 zeigt eine beispielhafte zweite Darstellung eines ersten Befestigungselements 21.

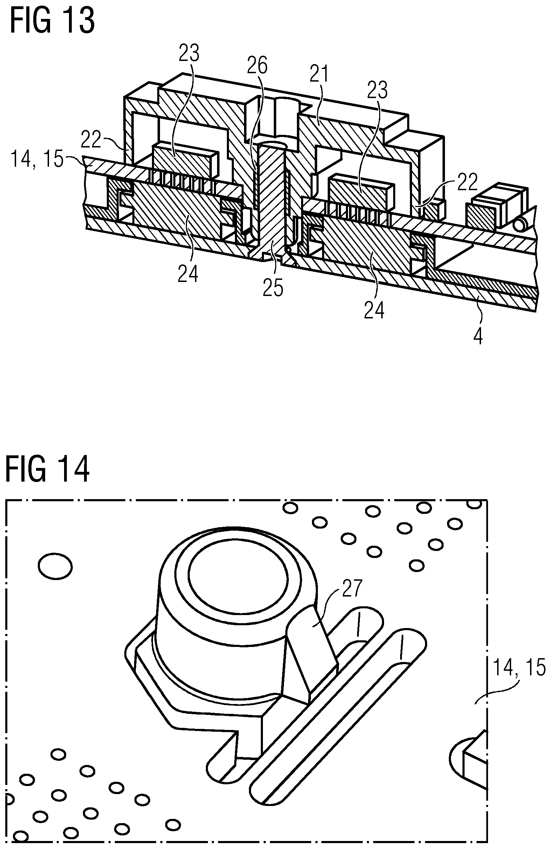

Fig. 13 zeigt eine beispielhafte dritte Darstellung eines ersten Befestigungselements 21 in einer Schnittdarstellung. Gezeigt ist das erste Befestigungselement 21 mit zwei Federarmen 22 und einem Körper mit innenliegender Ausnehmung, in der sich das Gewinde 26 befindet. Das erste Befestigungselement 21 ist an einer Leiterplatte 14, 15 befestigt. Entlang der Leiterplatte 14, 15 ist eine Isolierung 16, 17 angeordnet. Die Leiterplatte 14, 15 weist Ausnehmungen auf, in welchen Isolierkörper 24 angeordnet sind. Entlang der Isolierung 16, 17 und der Isolierkörper 24 ist der Kühlkörper 4, 6 angeordnet. Die Isolierkörper 24 sind elektrisch isolierend, beispielsweise aus Keramik ausgeführt, und kontaktieren die Leiterplatte 14, 15 thermisch in Bereichen erhöhter Wärmeentwicklung, beispielsweise dort, wo elektronische Bauelemente 23 angeordnet sind. Elektronische Bauelemente 23 mit erhöhter Wärmeentwicklung sind beispielsweise Gleichrichter oder PFC-Transistoren (PFC: "power factor correction", Deutsch: Leistungsfaktorkorrekturfilter). Auf der Leiterplatte 14, 15 sind zwischen den elektronischen Bauelementen 21 und den Isolierkörpern 24 Elemente zur besseren Wärmeübertragung durch die Leiterplatte 14, 15 angeordnet. Dies sind bspw. Vias oder Kupferhülsen. Die Federarme 22 und der Körper des ersten Befestigungselements 21 üben bevorzugt eine Kraft auf die Leiterplatte 14, 15 selbst aus und drücken damit die Leiterplatte 14, 15 auf die Isolierkörper 24. Damit kann der Wärmeübergang von elektronischen Bauelementen 23 mit unterschiedlichsten geometrischen Abmessungen verbessert werden, ohne dass das erste Befestigungselement 21 an diese geometrischen Abmessungen angepasst werden muss.

Fig. 13 zeigt weiters eine Verbindung des ersten Befestigungselements 21 mit der Anordnung bestehend aus Leiterplatte 14, 15, Isolierung 16, 17, Isolierkörper 24 und Kühlkörper 4, 6. In diesem Beispiel wird eine Schraube 25 durch den Kühlkörper 4, 6 in das Gewinde 26 des ersten Befestigungselements 21 eingeführt und gesichert. Der Rasthaken 27 verhindert ein Durchdrücken des ersten Befestigungselements 21 aus der Leiterplatte 14, 15 und der Verdrehschutz verhindert ein Verdrehen des ersten Befestigungselements. Durch die Verbindung wird ein optimaler Wärmeübergang von in elektronischen Bauelementen 23 entstehender Wärme durch den Isolierkörper 24 auf den Kühlkörper 4, 6 hergestellt. Wesentlich ist, dass die Verschraubung von einer Lötseite der Leiterplatte 14, 15 aus durchgeführt wird. Dies vereinfacht die Montage, da auf einer Bauteilseite der Leiterplatte 14, 15 kein Freiraum für einen Zugang für Montagewerkzeuge gelassen werden muss.

Fig. 14 zeigt eine beispielhafte vierte Darstellung eines ersten Befestigungselements 21. Dargestellt ist insbesondere der Rasthaken 27, der das erste Befestigungselement 21 in der Leiterplatte 14, 15 sichert. Die Leiterplatte 14, 15 weist einen flexiblen Bereich auf, über den der Rasthaken 27 beim Einführen gleitet und welcher sich flexibel zurückbewegt. Weiters ist der Verdrehschutz des ersten Befestigungselements 21 dargestellt.

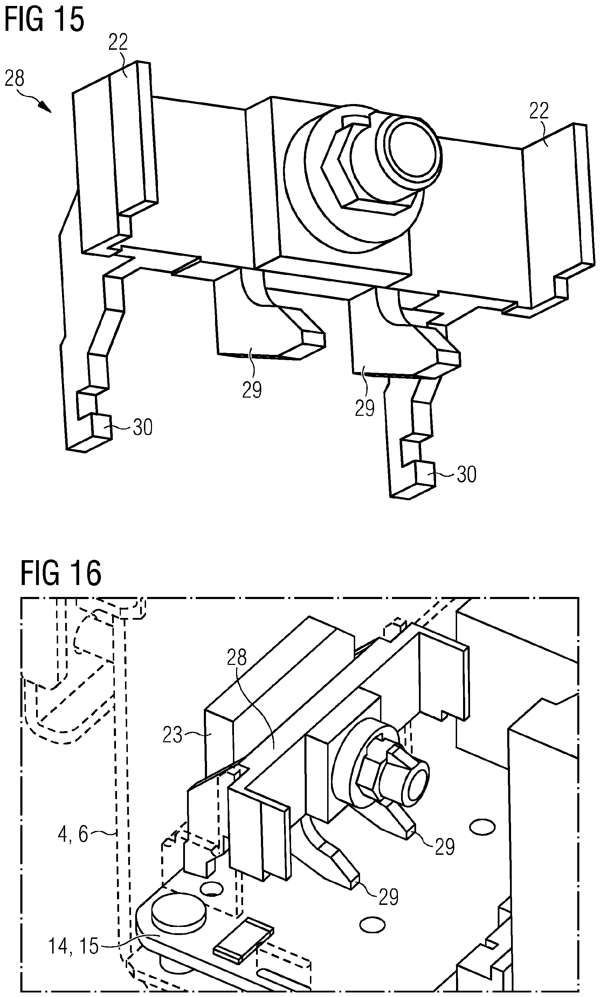

Fig. 15 zeigt eine beispielhafte erste Darstellung eines zweiten Befestigungselements 28. Das zweite Befestigungselement 28 umfasst einen Körper mit einem innenliegenden Gewinde 26. Durch den Körper des zweiten Befestigungselements 28 verläuft eine Ausnehmung, in der sich das Gewinde 26 befindet. Die Ausnehmung im Körper des zweiten Befestigungselements 28 verläuft parallel zur Leiterplatte 14, 15, wenn das zweite Befestigungselement 28 an der Leiterplatte 14, 15 angebracht ist. Das zweite Befestigungselement 28 umfasst weiters zumindest eine Abstützung 29 und einen Haken 30. In diesem Beispiel umfasst das zweite Befestigungselement 28 zwei Abstützungen 29 und zwei Haken 30. Mit den Haken 30 wird das zweite Befestigungselement 28 seitlich an der Leiterplatte 14, 15 angebracht. Die Abstützungen 29 verhindern ein Kippen des zweiten Befestigungselements 29 zur Leiterplatte 14, 15 hin.

Fig. 16 zeigt eine beispielhafte zweite Darstellung eines zweiten Befestigungselements 28. Dargestellt ist ein elektronisches Bauelement 23, welches zwischen dem zweiten Befestigungselement 28 und dem Kühlkörper 4, 6 angeordnet ist. Das elektronische Bauelement 23 weist eine nicht dargestellte, durch das elektronische Bauelement 23 durchgehende, Öffnung auf. Das elektronische Bauelement 23 ist mit einer nicht dargestellten Schraube mit dem Kühlkörper 4, 6 und dem zweiten Befestigungselement verschraubt. Die Schraube ist dabei vom Kühlkörper 4, 6 ausgehend durch die Öffnung des elektronischen Bauelements 23 in das Gewinde 26 des zweiten Befestigungselements 28 eingeführt. Die Abstützungen 29 verhindern ein Kippen des zweiten Befestigungselements 28 zur Leiterplatte 14, 15 hin beim Verschrauben. Durch die Verschraubung und das zweite Befestigungselement 28 wird das elektronische Bauelement 23 an den Kühlkörper 4, 6 angepresst. Die Verschraubung von der Seite des Kühlkörpers 4, 6 erleichtert eine Fertigung bzw. Montage des elektronischen Geräts 1, da im Bereich der Leiterplatte 14, 15 kein Freiraum für Werkzeuge zur Verschraubung berücksichtigt werden muss.

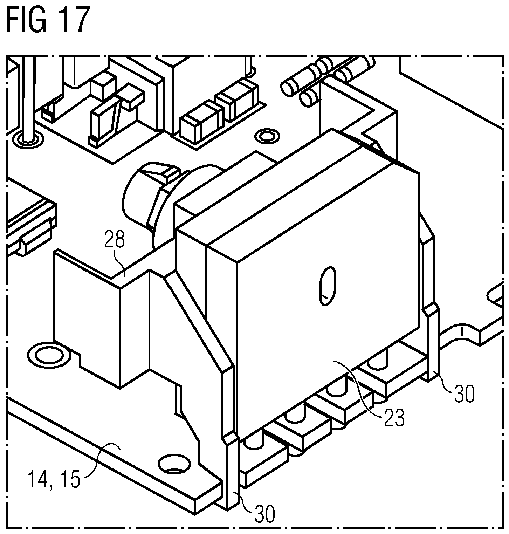

Fig. 17 zeigt eine beispielhafte dritte Darstellung eines zweiten Befestigungselements 28. Das zweite Befestigungselement 28 ist dabei in rückwärtiger Ansicht mit einem elektronischen Bauelement 23 dargestellt. Dargestellt ist weiters die durch das elektronische Bauelement 23 durchgehende, Öffnung. Nicht dargestellt sind der Kühlkörper 4, 6 und die Schraube zur Anpressung des elektronischen Bauelements 23 an den Kühlkörper 4, 6.

### Bezugszeichenliste

- 1: Elektronisches Gerät
- 2: Gehäuse
- 3: Erste elektronische Baugruppe
- 4: Erster Kühlkörper
- 5: Zweite elektronische Baugruppe
- 6: Zweiter Kühlkörper
- 7: Anpresselement
- 8: Zapfen
- 9: Ausnehmung
- 10: Verbindungsplatine
- 11: Erste Teil-Verbindungsplatine
- 12: Zweite Teil-Verbindungsplatine
- 13: Federelement
- 14: Erste Leiterplatte
- 15: Zweite Leiterplatte
- 16: Erste Isolierung
- 17: Zweite Isolierung
- 18: Lasche
- 19: Bügel
- 20: Platinenverbindung
- 21: Erstes Befestigungselement
- 22: Federarm
- 23: Elektronisches Bauelement
- 24: Isolierkörper
- 25: Schraube
- 26: Gewinde
- 27: Rasthaken
- 28: Zweites Befestigungselement
- 29: Abstützungen
- 30: Haken

## Patentansprüche

1. Elektronisches Gerät (1), insbesondere ein Stromversorgungssystem, umfassend
- ein Gehäuse (2);
- eine erste elektronische Baugruppe (3), insbesondere eine erste Stromversorgungseinheit, umfassend einen ersten Kühlkörper (4); und
- eine zweite elektronische Baugruppe (5), insbesondere eine zweite Stromversorgungseinheit, umfassend einen zweiten Kühlkörper (6);
- wobei die erste und die zweite elektronische Baugruppe (3, 5) im Gehäuse (2) angeordnet sind; und
- der erste Kühlkörper (4) und der zweite Kühlkörper (6) über Anpresselemente (7) innen an das Gehäuse (2) angepresst sind.

2. Elektronisches Gerät (1) nach Anspruch 1, wobei zumindest ein Anpresselement (7) als Zapfen (8) ausgebildet ist, der von der ersten und/oder zweiten elektronischen Baugruppe (3, 5) umfasst ist, wobei der Zapfen (8) mit Ausnehmungen (9) im Gehäuse (2) zusammenwirkt.

3. Elektronisches Gerät (1) nach einem der Ansprüche 1 oder 2, wobei das elektronische Gerät (1) weiters eine Verbindungsplatine (10) umfasst, über die die erste und die zweite elektronische Baugruppe (3, 5) elektrisch und mechanisch miteinander verbunden sind, und zumindest ein Anpresselement als Federelement (13) ausgebildet ist, welches von der Verbindungsplatine (10) umfasst ist.

4. Elektronisches Gerät (1) nach Anspruch 3, wobei die Verbindungsplatine (10) in eine erste Teil-Verbindungsplatine (11) und eine zweite Teil-Verbindungsplatine (12) zweigeteilt ist und das Federelement (13) eine Federung zwischen der ersten und der zweiten Teil-Verbindungsplatine (11, 12) bewirkt.

5. Elektronisches Gerät (1) nach Anspruch 4, wobei das Federelement (13) durch einen elastischen Fortsatz der ersten Teil-Verbindungsplatine (11) gebildet ist, der mit der zweiten Teil-Verbindungsplatine (12) zusammenwirkt.

6. Elektronisches Gerät (1) nach einem der Ansprüche 1 bis 5, wobei der erste und der zweite Kühlkörper (4, 6) an gegenüberliegende Seitenwände des Gehäuses (2) angepresst sind.

7. Elektronisches Gerät (1) nach einem der Ansprüche 1 bis 6, wobei die erste und die zweite elektronische Baugruppe (3, 5) eine gleiche elektrische Funktionalität aufweisen und parallelgeschaltet sind.

8. Elektronisches Gerät (1) nach einem der Ansprüche 1 bis 7, weiters umfassend ein erstes Befestigungselement (21), welches formschlüssig in einer ersten Leiterplatte (14) der ersten elektronischen Baugruppe (3) oder in einer zweiten Leiterplatte (15) der zweiten elektronischen Baugruppe (5) angeordnet ist; ein Gewinde (26) und zumindest einen Federarm (22) aufweist; und mit der ersten oder zweiten elektronischen Baugruppe (3, 5) derart verschraubt ist, dass durch das erste Befestigungselement (21), insbesondere durch den zumindest einen Federarm (22), eine Kraft ausgeübt ist, welche die erste Leiterplatte (14) an den ersten Kühlkörper (4) oder die zweite Leiterplatte (15) an den zweiten Kühlkörper (6) drückt.

9. Elektronisches Gerät (1) nach einem der Ansprüche 1 bis 8, weiters umfassend ein zweites Befestigungselement (28), welches seitlich an einer Leiterplatte (14, 15) befestigt ist und durch welches ein elektronisches Bauteil (23) zwischen dem Kühlkörper (4, 6) und dem zweiten Befestigungselement (28) an den Kühlkörper (4, 6) anpressbar ist.

10. Elektronisches Gerät (1) nach einem der vorangehenden Ansprüche, wobei das elektronische Gerät (1) ein Stromversorgungssystem, die erste elektronische Baugruppe (3) eine erste Stromversorgungseinheit und die zweite elektronische Baugruppe (5) eine zweite Stromversorgungseinheit ist.

11. Verfahren zur Montage eines elektronischen Geräts (1) nach einem der Ansprüche 1 bis 10, wobei die erste und die zweite elektronische Baugruppe (3, 5) in das Gehäuse eingeschoben werden und der erste Kühlkörper (4) und der zweite Kühlkörper (6) über Anpresselemente (7) innen an das Gehäuse (2) angepresst werden.

12. Verfahren nach Anspruch 11, wobei das elektronische Gerät (1) einem der Ansprüche 4 oder 5 ausgebildet ist, und wobei die erste und die zweite Teil-Verbindungsplatine (11, 12) elektrisch miteinander verbunden werden.
